# EUROPÄISCHE PATENTANMELDUNG

(11) **EP 1 239 292 A2**
(43) Veröffentlichungstag der Anmeldung: **11.09.2002**
(21) Anmeldenummer: 02450043.1
(22) Anmeldetag: 04.03.2002
(51) Int. Cl.: G01R 27/20, H01R 4/66

(54) **Einrichtung zur Unterstützung der Messung des Erdwiderstandes**

(30) Priorität: 08.03.2001 AT 1742001 U
(71) Anmelder: Lem Norma GmbH, 2345 Brunn am Gebirge (AT)
(72) Erfinder: Göbelhaider, Jürgen, 2345 Brunn am Gebirge (AT)
(74) Vertreter: Heger, Georg, Dipl.-Ing., Dr.

(57) **Zusammenfassung**

Die Erfindung betrifft eine Einrichtung zur Unterstützung der Messung des Erdwiderstandes mit einem Erdspieß (1) mit einem auf einer Haspel (3) od. dgl. aufgewickelten Kabel (2), und mit elektrischen Verbindungsmitteln zum Verbinden des Kabels (2) mit dem Erdspieß (1). Zur Schaffung einer derartigen Einrichtung, welche praktisch handhabbar und einfach, klein und kostengünstig herstellbar ist, ist vorgesehen, dass die Haspel (3) od. dgl. auf dem Erdspieß (1) drehbar gelagert ist. Eine weitere Verbesserung ergibt sich dadurch, dass der Erdspieß eine Kröpfung (11) aufweist, in deren Bereich die Haspel (3) od. dgl. drehbar gelagert ist. Bevorzugterweise weisen die elektrischen Verbindungsmittel zwischen Erdspieß (1) und Kabel (2) Schleifringe (12) auf der Drehachse (9), der Haspel (3) od. dgl., auf. Zur raschen Austauschbarkeit der Haspel (3) kann diese über eine Schnappverbindung (17) am Erdspieß (1) montiert sein.

## Beschreibung

Die Erfindung betrifft eine Einrichtung zur Unterstützung der Messung des Erdwiderstandes mit einem Erdspieß mit einem auf einer Haspel od. dgl. aufgewickelten Kabel, und mit elektrischen Verbindungsmitteln zum Verbinden des Kabels mit dem Erdspieß.

Messungen des Erdungswiderstandes sind ein wesentlicher Bestandteil zur Sicherstellung der Sicherheitsvorkehrungen und Schutzmaßnahmen bei Erzeugung, Verteilung und Nutzung elektrischer Energie. Diese Schutzmaßnahmen, wobei ein wesentlicher Teil die Messung des Erdungswiderstandes darstellt, sind in nationalen bzw. internationalen Vorschriften festgelegt und regelmäßig zu überprüfen. Die Messung des Erdungswiderstandes wird z.B. am Transformatorbetriebserdern, Hoch- und Mittelspannungsmasten, Gleiskörpern, Tank- und Kesselanlagen, Fundamenterdungen und auch Blitzschutzanlagen sowie bei Hausinstallationen durchgeführt. Zu diesem Zweck werden meist zwei sogenannte Erdspieße in einem gewissen Abstand voneinander in die Erde gerammt oder gedreht und diese mit einem Kabel elektrisch mit einem Messgerät verbunden. Eine weitere Verbindung wird zwischen dem Messgerät und dem zu überprüfenden, geerdeten Objekt, beispielsweise einem Leitungsmast, hergestellt. Auf diese Weise wird der Erdungswiderstand des geerdeten Objekts gemessen. Wenn der Wert einen oberen Grenzwert überschreitet, ist dies ein Anzeichen für eine unzureichende Erdung.

Beispielsweise beschreibt die FR 2 668 138 A1 eine Einrichtung zur Messung des Erdwiderstandes, welche aus mehreren Erdspießen besteht, die über eine Schraubklemme mit einem Kabel elektrisch verbunden werden kann. Mehrere Haspeln, auf denen das Verbindungskabel aufgewickelt werden kann, sind drehbar auf einer Welle gelagert, welche von einem Motor angetrieben werden kann. Die auf der Welle befindlichen Haspeln mit den Verbindungskabeln zusammen mit dem Antriebsmotor sind in einer Kiste angeordnet, welche beispielsweise auf der Ladefläche eines Kraftfahrzeugs positioniert werden kann. Diese Art der Einrichtung ist sehr groß und aufwendig und eignet sich daher nur für umfangreiche Erdungsmessungen bei spezifischen Anwendungen.

Ein Erdspieß mit einer Verbindungsklemme für das Kabel ist beispielsweise aus der US 6 137 049 A bekannt, wobei das Kabel in den Schlitz einer Hülse eingeführt wird und danach diese Hülse auf das obere Ende des Erdspießes gepresst wird. Dadurch wird eine zuverlässige Verbindung des Kabels mit dem Erdspieß erzielt.

Abgesehen von solchen Klemmverbindungen können die Kabel auch mit Klemmschrauben am Erdspieß befestigt werden. Solche Erdspieße werden beispielsweise in der WO 98/45895 A1 oder WO 99/27613 A1 beschrieben.

Aufgabe der vorliegenden Erfindung ist die Schaffung einer oben angegebenen Einrichtung zur Unterstützung der Erdungsmessung, welche praktisch handhabbar und einfach, klein und kostengünstig herstellbar ist. Nachteile bekannter Einrichtungen sollen vermieden bzw. reduziert werden.

Gelöst wird die erfindungsgemäße Aufgabe dadurch, dass die Haspel od. dgl. auf dem Erdspieß drehbar gelagert ist. Somit resultiert eine einfache Einheit, welche vom jeweiligen technischen Personal leicht an den Ort der Messung gebracht werden kann, indem der Erdspieß mit der Haspel in die Erde gedreht oder gerammt wird und danach das Verbindungskabel von der Haspel abgerollt wird. Je nach notwendiger Länge des Verbindungskabels können größere oder kleinere Haspeln am Erdspieß drehbar gelagert werden.

Wenn der Erdspieß eine Kröpfung aufweist, in deren Bereich die Haspel od. dgl. drehbar gelagert ist, resultiert eine kompaktere und platzsparendere Einrichtung. Solche mit einer Haspel versehene Erdspieße können beispielsweise in einem dafür vorgesehenen Werkzeugkoffer od. dgl. eingebettet werden und vom jeweiligen technischen Personal leicht an den Messort transportiert werden.

Vorteilhafterweise weisen die notwendigen elektrischen Verbindungsmittel zwischen Erdspieß und Kabel Schleifringe auf der Drehachse der Haspel od. dgl. auf. Somit muss das auf der Haspel aufgerollte Verbindungskabel lediglich mit der Achse bzw. den Schleifringen verbunden werden, wodurch automatisch bei drehbarer Verbindung der Haspel mit dem Erdspieß eine elektrische Verbindung des Kabels mit dem Erdspieß gegeben ist. Durch entsprechend elektrisch leitende Schmierstoffe kann eine Erhöhung der Leitfähigkeit über die Achse erreicht werden.

Alternativ dazu können die elektrischen Verbindungsmittel. zwischen Erdspieß und Kabel Steckverbindungen aufweisen. Zu diesem Zweck kann die Buchse fest mit dem Erdspieß, und der Stecker mit dem Verbindungskabel elektrisch verbunden sein. Ebenso kann in an sich bekannter Weise eine Klemmschraube am Erdspieß vorgesehen sein und mit dem vom Inneren der Haspel herausgeführten Kabelende verbunden werden.

Vorteilhafterweise ist die Haspel od. dgl. am Erdspieß abnehmbar montiert. Dadurch kann die Einrichtung zur Messung des Erdwiderstandes, beispielsweise für den Transport, verkleinert werden. Weiters ist auch möglich, dass verschieden große Haspeln mit unterschiedlichen Kabellängen mit ein und demselben Erdspieß verbunden werden.

Die abnehmbare Montage der Haspel am Erdspieß erfolgt vorteilhafterweise über eine Schnappverbindung, so dass die Verbindung rasch und einfach durchgeführt werden kann.

Zur leichteren Handhabung des Aufwickelns des Kabels weist die Haspel od. dgl. eine vorzugsweise abnehmbare oder anklappbare Kurbel auf. Durch diese kann das Aufwickeln des Kabels leichter und rascher erfolgen. Die Abnehmbarkeit oder Verschwenkbarkeit erleichtert wiederum den Transport der Einrichtung, da eine kompaktere Einheit gebildet wird.

Für größere Kabellängen kann es zweckmäßig sein, dass die Haspel od. dgl. mit einer Antriebseinrichtung, beispielsweise einer Aufrollfeder, versehen ist. Durch eine derartige Maßnahme wird das Aufrollen des Kabels wesentlich erleichtert.

Die Erfindung wird anhand der Zeichnungen, welche ein Ausführungsbeispiel der Erfindung zeigen, noch weiter erläutert.

Darin zeigen:
Fig. 1a und 1b Prinzipskizzen des Erdungsmessverfahrens nach dem Stand der Technik,
Fig. 2 eine Seitenansicht einer Ausführungsform einer erfindungsgemäßen Einrichtung,
Fig. 3 eine Ansicht auf die Einrichtung gemäß Fig. 2 von vorne, die
Fig. 4 bis 6 in Detailansichten, teilweise im Schnitt, verschiedene Ausführungsformen zur elektrischen Verbindung von Kabel und Erdspieß, und
Fig. 7 eine Ausführungsform eines Schnappverschlusses zur abnehmbaren Montage der Haspel am Erdspieß.

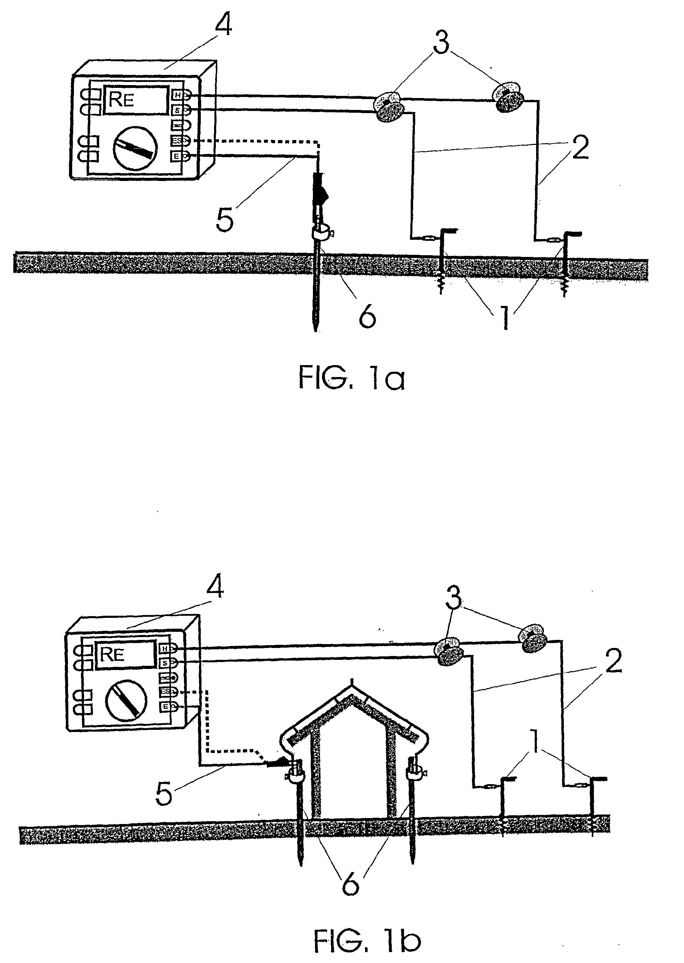

Fig. 1a zeigt eine Prinzipskizze einer Erdungsmessung an einem geerdeten Objekt oder Gerät 6, beispielsweise einem Leitungsmast. Dabei werden zwei Erdungsspieße 1 in einem gewissen Abstand voneinander in die Erde eingedreht oder eingesteckt. Die Erdungsspieße 1 werden über ein Kabel 2 mit einem Messgerät 4 verbunden, wobei das Kabel 2 meistens auf einer Haspel 3 aufgewickelt ist und entsprechend den Erfordernissen abgewickelt wird. Das zu messende Objekt oder Gerät 6 wird über ein Kabel 5 ebenfalls mit dem Messgerät 4 verbunden. Über einen der beiden Erdspieße 1, dem sogenannten Hilfserder, wird ein Messstrom eingespeist, während über dem anderen Erdspieß 1, die sogenannte Sonde, der Spannungsabfall an dem zwischen diesem Erdspieß und dem Gerät 6 auftretenden Widerstand gemessen wird, wodurch in Kenntnis des eingeprägten Stromes und des gemessenen Spannungsabfalles auf den Widerstand rückgeschlossen werden kann. Im Falle zu großer Leitungen zwischen dem Messgerät 4 und dem zu messenden Objekt oder Gerät 6 kann mit Hilfe einer zusätzlichen Messleitung (strichliert gezeichnet) eine Kompensation des durch diese Leitung auftretenden Spannungsabfalls nach dem bekannten alternativen Vier-Pol-Messverfahren erfolgen. Dadurch wird ein Fehler des Messergebnisses durch den Widerstand der Messleitung 5 eliminiert. Wird mit Hilfe des Messgerätes 4 ein zu hoher Widerstandswert gemessen, weist dieser auf eine unzureichende Erdung des geerdeten Objekts oder Geräts 6 hin.

Fig. 1b zeigt das Prinzip einer Erdungsmessung an der Blitzschutzanlage eines Hauses. Sonst erfolgt die Messung analog zu jener gemäß Fig. 1a.

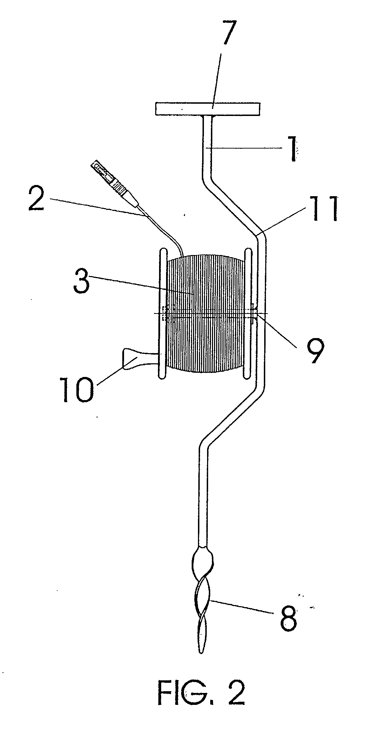

Fig. 2 zeigt eine Seitenansicht einer Ausführungsform einer erfindungsgemäßen Einrichtung, bestehend aus dem Erdspieß 1, der zur besseren Handhabung einen Griff 7 und an dem in die Erde zu steckenden Ende eine Spitze, ein Gewinde 8 od. dgl. aufweist. Die Haspel 3 mit dem darauf aufgewickelten Kabel 2 ist drehbar an dem Erdspieß 1 gelagert. Zu diesem Zweck ist eine Drehachse 9 am Erdspieß 1 befestigt, beispielsweise angeschweißt. Zum leichteren Aufwickeln des Kabels 2 ist an der Haspel 3 ein Kurbelgriff 10 befestigt, der vorzugsweise abnehmbar oder an die vordere Haspelscheibe anklappbar ist, so dass die Einrichtung sehr kompakt ist. Die Einrichtung ist auch dadurch besonders kompakt und gut handhabbar, dass der Erdspieß 1 eine Kröpfung 10 aufweist, in deren Bereich die Haspel 3 od. dgl. drehbar gelagert ist.

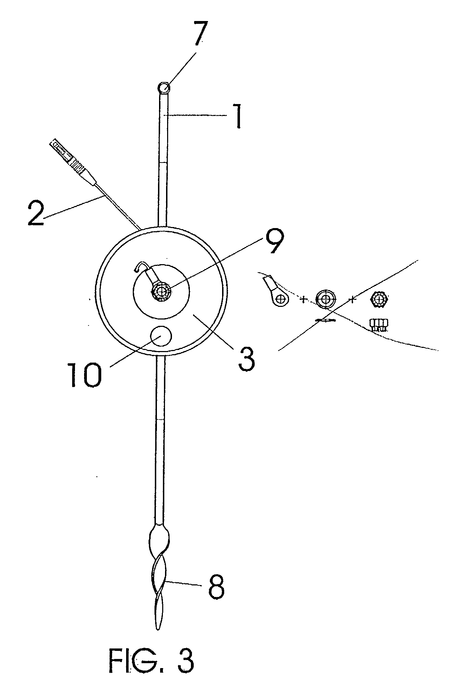

Wie der Fig. 3 entnommen werden kann, ist die Haspel 3 zylindrisch ausgeführt, sie kann jedoch auch elliptischen oder ovalen Querschnitt aufweisen. Eine derartige Ausführung hat manchmal hinsichtlich des Platzerfordernisses Vorteile, wenn nämlich die Einrichtung zu Transportzwecken in einem Koffer unterzubringen ist.

Zur Herstellung der elektrischen Verbindung zwischen dem Kabel 2 auf der Haspel 3 od. dgl. und dem Erdspieß 1 kann ein freies Ende des Kabels 2 aus der Haspel 3 od. dgl. herausgeführt und beispielsweise über eine Schraubverbindung mit der Drehachse 9 verbunden werden.

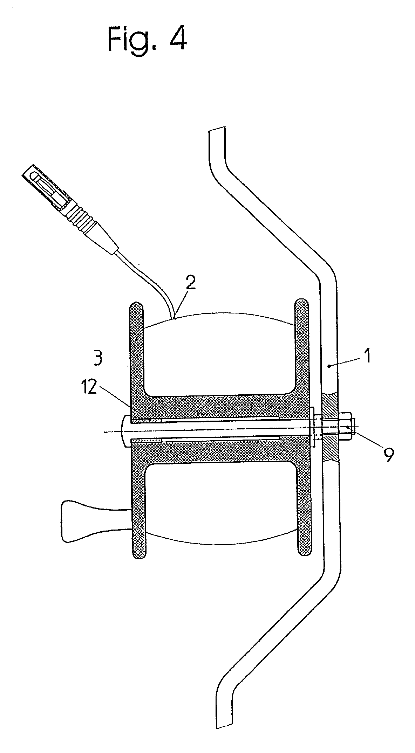

Fig. 4 zeigt eine Möglichkeit der Herstellung der elektrischen Verbindung zwischen dem Kabel 2 auf der Haspel 3 od. dgl. und dem Erdspieß 1, welcher über Schleifringe 12 und die Drehachse 9 erfolgen kann.

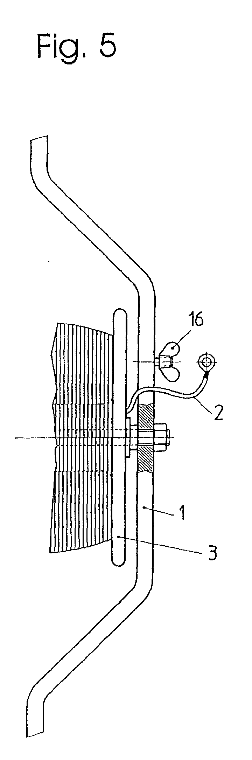

Fig. 5 zeigt eine weitere Ausführungsform, bei der das innere Ende des auf der Haspel 3 od. dgl. aufgewickelten Kabels 2 nach dem Abwickeln der erforderlichen Kabellänge durch Drehen der Haspel 3 über eine Klemmschraube 16 mit dem Erdspieß 1 elektrisch verbunden wird.

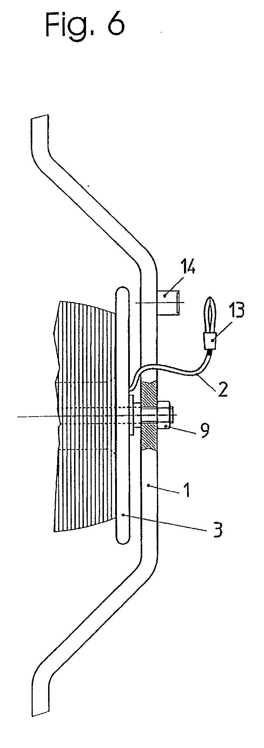

Diese Verbindung kann entsprechend Fig. 6 auch mit einer Steckverbindung erfolgen, wobei am freien Ende des Kabels 2 ein Stecker 13 und am Erdspieß 1 eine Buchse 14 befestigt sind, welche bei Bedarf zusammengesteckt werden können.

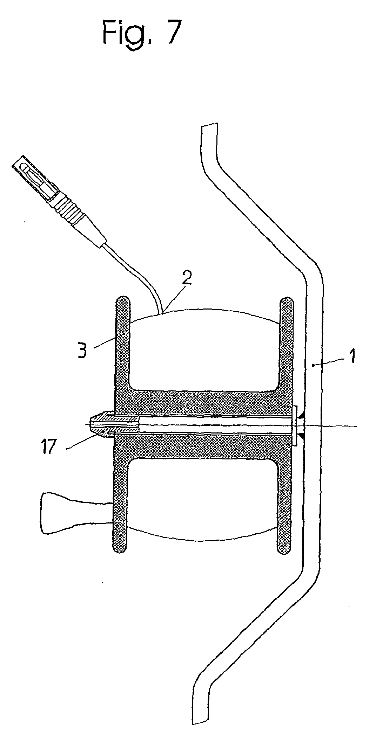

Fig. 7 zeigt eine Ausführungsform einer lösbaren mechanischen Verbindung zwischen Haspel 3 und Erdspieß 1, wobei die Drehachse mit einer Schnappverbindungseinrichtung 17 ausgeführt ist, auf die die Haspel 3 einfach aufgesteckt werden kann. Dadurch können verschiedene Haspeln 3 mit verschiedenen Kabeln 2, insbesondere verschiedenen Kabellängen, leicht ausgetauscht und auf den Erdspieß 1 aufgesteckt werden.

Schließlich kann eine Antriebseinrichtung für die Haspel, welche das Aufrollen des Kabels unterstützt, vorgesehen sein (nicht dargestellt). Diese kann beispielsweise durch eine Aufrollfeder gebildet sein, welche in ähnlicher Weise wie bei einem Rollo gespannt wird und bei Betätigung eines Knopfes, der beispielsweise eine Sägezahnrastsperre außer Betrieb setzt, das Aufrollen des Kabels auf der Haspel unterstützt. Es sind allerdings auch andere Antriebseinrichtungen, wie beispielsweise batteriebetriebene Motoren od. dgl., möglich.

Die beschriebene Einrichtung zur Messung des Erdwiderstands zeichnet sich durch eine besondere Kompaktheit, Einfachheit und geringe Herstellungskosten aus.

## Patentansprüche

1. Einrichtung zur Unterstützung der Messung des Erdwiderstandes mit einem Erdspieß (1) mit einem auf einer Haspel (3) od. dgl. aufgewickelten Kabel (2), und mit elektrischen Verbindungsmitteln zum Verbinden des Kabels (2) mit dem Erdspieß (1), **dadurch gekennzeichnet, dass** die Haspel (3) od. dgl. auf dem Erdspieß (1) drehbar gelagert ist.

2. Einrichtung nach Anspruch 1, **dadurch gekennzeichnet, dass** der Erdspieß eine Kröpfung (11) aufweist, in deren Bereich die Haspel (3) od. dgl. drehbar gelagert ist.

3. Einrichtung nach Anspruch 1 oder 2, **dadurch gekennzeichnet, dass** die elektrischen Verbindungsmittel zwischen Erdspieß (1) und Kabel (2) Schleifringe (12) auf der Drehachse (9) der Haspel (3) od. dgl., aufweisen.

4. Einrichtung nach Anspruch 1 oder 2, **dadurch gekennzeichnet, dass** die elektrischen Verbindungsmittel zwischen Erdspieß (1) und Kabel (2) Steckverbindungen (12, 14) aufweisen.

5. Einrichtung nach einem der Ansprüche 1 bis 4, **dadurch gekennzeichnet, dass** die Haspel (3) od. dgl. am Erdspieß (1) abnehmbar montiert ist.

6. Einrichtung nach Anspruch 5, **dadurch gekennzeichnet, dass** die Haspel (3) od. dgl. über eine Schnappverbindung (17) am Erdspieß (1) montiert ist.

7. Einrichtung nach einem der Ansprüche 1 bis 6, **dadurch gekennzeichnet, dass** die Haspel (3) od. dgl. eine vorzugsweise abnehmbare oder anklappbare Kurbel (10) aufweist.

8. Einrichtung nach einem der Ansprüche 1 bis 6, **dadurch gekennzeichnet, dass** die Haspel (3) od. dgl. mit einer Antriebseinrichtung, beispielsweise einer Aufrollfeder, versehen ist.
